# EUROPEAN PATENT SPECIFICATION

(11) **EP 4 128 081 B1**
(45) Date of publication and mention of the grant of the patent: **18.11.2026**
(21) Application number: 21775534.7
(22) Date of filing: 25.03.2021
(51) Int. Cl.: G06N 10/40, H10N 60/12, G06N 10/60, B82Y 10/00

(54) **SYSTEMS AND METHODS FOR SCALABLE QUANTUM COMPUTING**
SYSTEME UND VERFAHREN ZUR SKALIERBAREN QUANTENBERECHNUNG
SYSTÈMES ET PROCÉDÉS DE CALCUL QUANTIQUE ÉVOLUTIF

(30) Priority: 27.03.2020 US 202063001014 P
(43) Date of publication of application: 08.02.2023
(60) Divisional application: 26210279.1
(73) Proprietor: D-Wave Systems Inc., Burnaby, BC V5G 4M (CA)
(72) Inventor: HARRIS, Richard, G., Burnaby, British Columbia, V5G 4M (CA)
(74) Representative: Murgitroyd & Company
(86) International application number: PCT/US2021/024134
(87) International publication number: WO 2021/195368

(56) References cited:
- WO-A2-2017/192733
- US-A1- 2012 124 432
- US-A1- 2018 247 217
- US-A1- 2018 341 874
- US-A1- 2020 036 332
- US-A1- 2020 036 332
- HARRIS R ET AL: "A Compound Josephson Junction Coupler for Flux Qubits With Minimal Crosstalk", ARXIV.ORG, CORNELL UNIVERSITY LIBRARY, 201 OLIN LIBRARY CORNELL UNIVERSITY ITHACA, NY 14853, 24 April 2009 (2009-04-24), XP080321184, DOI: 10.1103/PHYSREVB.80.052506
- AUSTIN G. FOWLER ET AL: "Surface codes: Towards practical large-scale quantum computation", PHYSICAL REVIEW A (ATOMIC, MOLECULAR, AND OPTICAL PHYSICS), vol. 86, no. 3, 26 October 2012 (2012-10-26), USA, XP055332246, ISSN: 1050-2947, DOI: 10.1103/PhysRevA.86.032324
- BUNYK P I ET AL: "Architectural considerations in the design of a superconducting quantum annealing processor", ARXIV.ORG, CORNELL UNIVERSITY LIBRARY, 201 OLIN LIBRARY CORNELL UNIVERSITY ITHACA, NY 14853, 21 January 2014 (2014-01-21), XP081343302, DOI: 10.1109/TASC.2014.2318294

## Description

### FIELD

This disclosure generally relates to systems and methods for scalable quantum computing, and, in particular, circuits for providing control and communicative coupling between devices.

### BACKGROUND

### Superconducting Processor

A computer processor may take the form of an analog processor, for instance a quantum processor such as a superconducting quantum processor. A superconducting quantum processor may include a number of qubits and associated local bias devices, for instance two or more superconducting qubits. Further detail and embodiments of exemplary quantum processors that may be used in conjunction with the present systems, methods, and apparatus are described in US Patent 7,533,068, US Patent 8,195,596, US Patent 8,190,548, and PCT Patent Application Serial No. PCT/US2009/037984.

A superconducting processor may be a processor that is not intended for quantum computing, and operates, for example, by principles that govern the operation of classical computer processors.

A computing system may in general include a quantum processor and/or a classical processor. A computing system may be a hybrid system that includes a quantum processor and a classical processor. In some implementations, at least one of the quantum processor and the classical processor is a superconducting processor.

### Superconducting Qubits

A superconducting quantum processor may include superconducting qubits. Superconducting qubits may be formed in a superconducting integrated circuit from superconducting material (*e.g.,* aluminum and/or niobium).

Superconducting qubits may be categorized by a physical property used to encode information in the qubits. For example, superconducting qubits may be categorized into charge, flux, and phase qubits. Charge qubits can store and manipulate information in charge states of the qubit. Flux qubits can store and manipulate information in a variable related to a magnetic flux through a portion of the qubit. Phase qubits can store and manipulate information in a variable related to a difference in a superconducting phase between two regions of the qubit. Hybrid devices can use two or more of charge, flux and phase degrees of freedom.

Superconducting qubits commonly include at least one Josephson junction. A Josephson junction is a small interruption in an otherwise continuous superconducting current path and is typically realized by a thin insulating barrier sandwiched between two superconducting electrodes. A Josephson junction can be formed as a three-layer or "trilayer" structure. Superconducting qubits are further described in, for example, US Patent 7,876,248, US Patent 8,035,540, and US Patent 8,098,179.

Some implementations of superconducting flux qubits include a superconducting loop (also referred to in the present application as a qubit loop) that is interrupted by at least one Josephson junction. Some implementations include multiple superconducting loops connected in series and/or in parallel with one another. Some implementations include multiple Josephson junctions connected either in series or in parallel with one another.

A pair of Josephson junctions that are connected in parallel with each another is referred to as a compound Josephson junction (CJJ). It is understood that the behavior of a CJJ may be modeled as a single effective Josephson junction, similar to the way in which the behavior of multiple resistors connected in parallel with one another may be modeled as a single effective resistance.

A compound Josephson junction in which at least one of the constituent Josephson junctions is itself a compound Josephson junction is referred to in the present application as a compound-compound Josephson junction (CCJJ).

### Hamiltonian Description of a Quantum Processor

In accordance with some implementations of the present systems and devices, a quantum processor may be designed to perform adiabatic quantum computation and/or quantum annealing. A common problem Hamiltonian includes a first component proportional to diagonal single-qubit terms and a second component proportional to diagonal multi-qubit terms, and may be expressed, for example, as follows: ${H}_{p} ∝ - \frac{ε}{2} \left[{\sum }_{i = 1}^{N} {h}_{i} {{σ}_{i}}^{z} + {\sum }_{j > i}^{N} {J}_{ij} {{σ}_{i}}^{z} {{σ}_{j}}^{z}\right]$ where N represents the number of qubits, *σᵢ^{z}* is a Pauli *z*-matrix for the *i^{th}* qubit, *hᵢ* and *Jᵢⱼ* are dimensionless local fields for the qubits and couplings between qubits, respectively, and *ε* is a characteristic energy scale for *Hₚ*.

The term *σᵢ^{z}* is an example of a diagonal single-qubit term, and the term *σᵢ^{z}σⱼ^{z}* is an example of a diagonal two-qubit term. A Hamiltonian may be physically realized by an implementation of superconducting qubits, for example.

The foregoing examples of the related art and limitations related thereto are intended to be illustrative and not exclusive. Other limitations of the related art will become apparent to those of skill in the art upon a reading of the specification and a study of the drawings.

### BRIEF SUMMARY

A superconducting circuit, albeit not claimed, may be summarized as comprising a Josephson parametric amplifier, the Josephson parametric amplifier comprising a pair of superconducting resonators; a compound-compound Josephson junction, the compound-compound Josephson junction superconductingly electrically communicatively coupled between the pair of superconducting resonators; and a first control circuit, wherein the first control circuit is communicatively coupled to the compound-compound Josephson junction.

In some implementations, the first control circuit is inductively communicatively coupled to the compound-compound Josephson junction.

In some implementations, the first control circuit comprises an analog DC current bias, the analog DC current bias communicatively coupled to the compound-compound Josephson junction of the Josephson parametric amplifier; a digital-to-analog converter (DAC), the DAC communicatively coupled to the compound-compound Josephson junction of the Josephson parametric amplifier; and a first microwave drive communicatively coupled to a first tunable mutual inductance, wherein the first tunable mutual inductance is communicatively coupled to the compound-compound Josephson junction of the Josephson parametric amplifier. In some implementations, the first tunable mutual inductance of the first control circuit is inductively communicatively coupled to the compound-compound Josephson junction of the Josephson parametric amplifier. In some implementations, the analog DC current bias and the DAC of the first control circuit are inductively communicatively coupled to the compound-compound Josephson junction of the Josephson parametric amplifier. In some implementations, the first tunable mutual inductance comprises a superconducting loop interrupted by a compound Josephson junction.

In some implementations, the first control circuit is operable to control strengths of *X*-terms and *Z*-terms of an effective Hamiltonian via a resonant drive at a first angular frequency, and via a parametric drive at a second angular frequency, the second angular frequency equal to a difference between twice the first angular frequency and a time-dependent de-tuning frequency.

In some implementations, the superconducting circuit further comprising a second control circuit, the second control circuit comprising a second microwave drive communicatively coupled to a second tunable mutual inductance, wherein the second tunable mutual inductance is communicatively coupled to the compound-compound Josephson junction of the Josephson parametric amplifier. In some implementations, the second control circuit is inductively communicatively coupled to the compound-compound Josephson junction. In some implementations, the second tunable mutual inductance of the second control circuit is inductively communicatively coupled to the compound-compound Josephson junction of the Josephson parametric amplifier. In some implementations, the second tunable mutual inductance comprises a superconducting loop interrupted by a compound Josephson junction.

In some implementations, each resonator of the pair of superconducting resonators is a superconducting microwave resonator. In some implementations, the superconducting microwave resonator is a coaxial transmission line resonator. In some implementations, the superconducting microwave resonator is a ladder circuit comprising a plurality of LC circuits electrically communicatively coupled in series with one another.

A method of operation of a hybrid computing system, albeit not claimed, may be summarized as comprising a digital processor and a superconducting circuit, the superconducting circuit comprising at least one Josephson parametric amplifier, a resonant drive, and a parametric drive, the method comprising setting by the digital processor a first angular frequency of the resonant drive; setting by the digital processor a second angular frequency of the parametric drive, the second angular frequency equal to a difference between twice the first angular frequency and a de-tuning frequency; and controlling by the digital processor a strength of an *X*-term and a *Z*-term of an effective Hamiltonian of the superconducting circuit by varying the de-tuning frequency.

A superconducting circuit, albeit not claimed, may be summarized as comprising a first, a second, a third, and a fourth superconducting qubit, wherein the first, the second, the third, and the fourth qubits are communicatively coupled by a 4-qubit even-parity stabilizer. In some implementations, the 4-qubit even-parity stabilizer comprises a superconducting stabilizer loop, the superconducting stabilizer loop which includes a material that is superconducting at or below a first critical temperature; a first inductance of the superconducting stabilizer loop, the first inductance inductively communicatively coupled to an inductance of the first superconducting qubit; a second inductance of the superconducting stabilizer loop, the second inductance inductively communicatively coupled to an inductance of the second superconducting qubit; a third inductance of the superconducting stabilizer loop, the third inductance inductively communicatively coupled to an inductance of the third superconducting qubit; a fourth inductance of the superconducting stabilizer loop, the fourth inductance inductively communicatively coupled to an inductance of the fourth superconducting qubit; and a parity-enforcing superconducting qubit, wherein the parity-enforcing qubit is communicatively coupled to the superconducting loop.

In some implementations, each of the first, the second, the third, the fourth, and the parity-enforcing superconducting qubits is a superconducting flux qubit. In some implementations, each of the first, the second, the third, and the fourth superconducting flux qubits includes a respective compound-compound Josephson junction. In some implementations, each of the first, the second, the third, and the fourth superconducting flux qubits comprises a respective superconducting qubit loop, the respective superconducting qubit loop which includes a material that is superconducting at or below a second critical temperature, each superconducting qubit loop comprising a respective crossover. In some implementations, the parity-enforcing superconducting flux qubit is communicatively coupled to the superconducting loop by a fully galvanic CJJ coupling device.

A quantum processor, in accordance with claim 1, is comprising a first, a second, a third, and a fourth Josephson parametric amplifier, wherein the first, the second, the third, and the fourth parametric amplifiers are logical qubits and are communicatively coupled to one another by a 4-qubit even-parity stabilizer auxiliary qubit. In a preferred embodiment, each of the first, the second, the third, and the fourth Josephson parametric amplifiers comprises a respective pair of superconducting microwave resonators, each superconducting microwave resonator of the respective pair of superconducting microwave resonators communicatively coupled to each other by a compound-compound Josephson junction. Further in accordance with claim 1, the 4-qubit even-parity stabilizer includes a superconducting loop, the superconducting loop which includes a material that is superconducting at or below a critical temperature, the superconducting loop which includes a crossover, a first segment on a first side of the crossover and a second segment on a second side of the crossover, the first and second segment of the superconducting loop galvanically isolated from each other at the crossover; a first, a second, a third, and a fourth inductance of the superconducting loop, each of the first, the second, the third, and the fourth inductance inductively communicatively coupled to an inductance of a respective Josephson parametric amplifier; and a parity-enforcing Josephson parametric amplifier, wherein the parity-enforcing Josephson parametric amplifier is communicatively coupled to the superconducting loop. In a preferred embodiment, each of the first, the second, the third and the fourth Josephson parametric amplifiers comprises a respective compound-compound Josephson junction, and a respective first control circuit communicatively coupled to the respective compound-compound Josephson junction of the first, the second, the third and the fourth Josephson parametric amplifiers. In a preferred embodiment, each respective first control circuit may be inductively communicatively coupled to the respective compound-compound Josephson junction of the first, the second, the third and the fourth Josephson parametric amplifiers. In a preferred embodiment, each respective first control circuit may comprise an analog DC current bias, communicatively coupled to the respective compound-compound Josephson junction of the first, the second, the third and the fourth Josephson parametric amplifiers, a digital-to-analog converter (DAC) communicatively coupled to the respective compound-compound Josephson junction of the first, the second, the third and the fourth Josephson parametric amplifiers, and a respective first microwave drive communicatively coupled to a respective first tunable mutual inductance communicatively coupled to the respective compound-compound Josephson junction of the first, the second, the third and the fourth Josephson parametric amplifiers. In a preferred embodiment, the respective first tunable mutual inductance of each of the respective first control circuit may be inductively communicatively coupled to the respective compound-compound Josephson junction of the first, the second, the third and the fourth Josephson parametric amplifiers. In a preferred embodiment, each of the analog DC current bias and each of the DAC of the respective first control circuit may be inductively communicatively coupled to the respective compound-compound Josephson junction of the first, the second, the third and the fourth Josephson parametric amplifiers. In a preferred embodiment, each of the respective first tunable mutual inductances may comprise a superconducting loop interrupted by a compound Josephson junction. In a preferred embodiment, each respective first control circuit may be operable to control strengths of *X*-terms and *Z*-terms of an effective Hamiltonian via a resonant drive at a first angular frequency, and via a parametric drive at a second angular frequency, the second angular frequency equal to a difference between twice the first angular frequency and a time-dependent de-tuning frequency. In a preferred embodiment, each of the first, the second, the third and the fourth Josephson parametric amplifiers may further comprise a respective second control circuit, each respective second control circuit comprising a respective second microwave drive communicatively coupled to a respective second tunable mutual inductance, wherein each respective second tunable mutual inductance is communicatively coupled to the respective compound-compound Josephson junction of the first, the second, the third and the fourth Josephson parametric amplifiers. In a preferred embodiment, each respective second control circuit may be inductively communicatively coupled to the respective compound-compound Josephson junction of the first, the second, the third and the fourth Josephson parametric amplifiers. In a preferred embodiment, each respective second tunable mutual inductance of the respective second control circuit may be inductively communicatively coupled to the respective compound-compound Josephson junction of the first, the second, the third and the fourth Josephson parametric amplifiers. In a preferred embodiment, each respective second tunable mutual inductance may comprise a superconducting loop interrupted by a compound Josephson junction. In a preferred embodiment, each resonator of the respective pair of superconducting resonators of the first, the second, the third, and the fourth Josephson parametric amplifiers may be a superconducting microwave resonator. In a preferred embodiment, each of the superconducting microwave resonators in the respective pair of superconducting resonators of the first, the second, the third, and the fourth Josephson parametric amplifiers may be a coaxial transmission line resonator. In a preferred embodiment, each superconducting microwave resonator in the respective pair of superconducting resonators of the first, the second, the third, and the fourth Josephson parametric amplifiers may be a ladder circuit comprising a plurality of LC circuits electrically communicatively coupled in series with one another.

### BRIEF DESCRIPTION OF THE SEVERAL VIEWS OF THE DRAWING(S)

In the drawings, identical reference numbers identify similar elements or acts. The sizes and relative positions of elements in the drawings are not necessarily drawn to scale. For example, the shapes of various elements and angles are not necessarily drawn to scale, and some of these elements may be arbitrarily enlarged and positioned to improve drawing legibility. Further, the particular shapes of the elements as drawn are not necessarily intended to convey any information regarding the actual shape of the particular elements and may have been solely selected for ease of recognition in the drawings.
FIG. 1A is a schematic diagram of an example implementation of a 4-qubit even-parity stabilizer.
FIG. 1B is a schematic diagram of another example implementation of a 4-qubit even-parity stabilizer.
FIG. 2 is a schematic diagram of an example implementation of a circuit comprising the 4-qubit stabilizer of FIG. 1B.
FIG. 3 is a schematic diagram of an example implementation of a Josephson parametric amplifier (JPA).
FIG. 4 is a schematic diagram of an example implementation of a building block that can be used to build a quantum annealing platform.
FIG. 5 is a schematic diagram of another example implementation of a building block that can be used to build a quantum annealing platform.
FIG. 6 is a schematic diagram of an example implementation of a circuit that includes a scalable JPA with scalable control biases.

### DETAILED DESCRIPTION

In the following description, certain specific details are set forth in order to provide a thorough understanding of various disclosed implementations. However, one skilled in the relevant art will recognize that implementations may be practiced without one or more of these specific details, or with other methods, components, materials, etc. In other instances, well-known structures associated with computer systems, server computers, and/or communications networks have not been shown or described in detail to avoid unnecessarily obscuring descriptions of the implementations.

Unless the context requires otherwise, throughout the specification and claims that follow, the word "comprising" is synonymous with "including," and is inclusive or open-ended (*i.e.,* does not exclude additional, unrecited elements or method acts).

Reference throughout this specification to "one implementation" or "an implementation" means that a particular feature, structure or characteristic described in connection with the implementation is included in at least one implementation. Thus, the appearances of the phrases "in one implementation" or "in an implementation" in various places throughout this specification are not necessarily all referring to the same implementation. Furthermore, the particular features, structures, or characteristics may be combined in any suitable manner in one or more implementations.

As used in this specification and the appended claims, the singular forms "a," "an," and "the" include plural referents unless the context clearly dictates otherwise. It should also be noted that the term "or" is generally employed in its sense including "and/or" unless the context clearly dictates otherwise.

The headings and Abstract of the Disclosure provided herein are for convenience only and do not interpret the scope or meaning of the implementations.

### Scalable Coupling

Multi-qubit interactions can include 2-local interactions. Multi-qubit interactions can also include *k*-local interactions where *k* > 2.

One architecture suitable for quantum annealing is described, for example, in Lechner W. et al., A QUANTUM ANNEALING ARCHITECTURE WITH ALL-TO-ALL CONNECTIVITY FROM LOCAL INTERACTIONS, Sci. Adv. 2015;1:e1500838 (referred to in the present application variously as the LHZ architecture and the LHZ scheme). Direct implementation of a 4-local coupling device (*e.g*., a nonlinear coupling device providing communicative coupling between four logical qubits) may be challenging. For example, an act of tuning qubit interactions using the 4-local coupling device may prove to be difficult, and a magnitude of interaction energies achievable in practice may be weaker than desired.

One approach to implementing a *4*-qubit even-parity stabilizer is to use one or more auxiliary qubits. A search over a space of discretized *2-*local couplings and *1*-local biases can reveal configurations that result in eight possible even-parity logical qubit states being degenerate ground states.

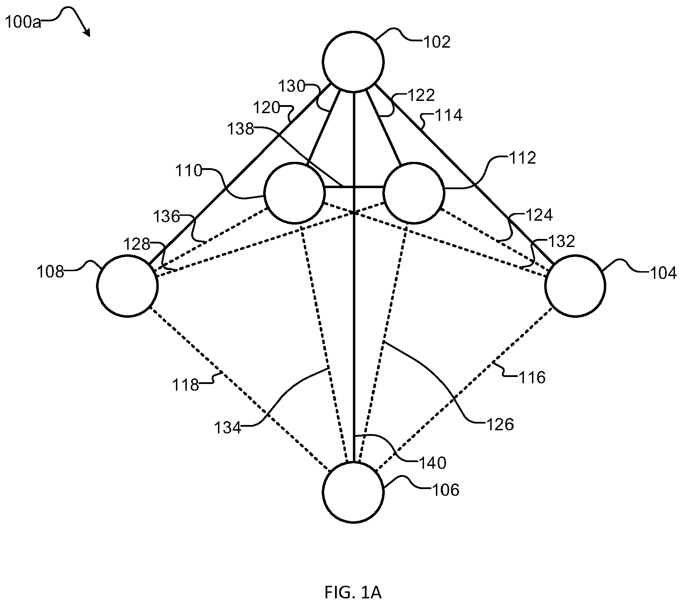

FIG. 1A is a schematic diagram of an example implementation of a 4-qubit even-parity stabilizer 100a. Stabilizer 100a is an example configuration of a *6*-qubit implementation of a *4*-qubit even-parity stabilizer.

Stabilizer 100a includes four logical qubits 102, 104, 106, and 108. In some implementations, a logical qubit (*e.g.,* one of logical qubits 102, 104, 106, and 108) includes more than one physical qubit and at least one communicative coupling device between physical qubits.

Stabilizer 100a includes two auxiliary qubits 110 and 112. Auxiliary qubits 110 and 112 can contribute to enforcing even parity.

Stabilizer 100a can be implemented using *2*-local interactions that are either *+1* or *-1.* An energy spacing between the *8*-fold degenerate ground states and the first excited state can take the value *2,* for example.

In FIG. 1A, ferromagnetic couplings between qubits are indicated by solid lines, and anti-ferromagnetic couplings between qubits are indicated by dashed lines.

Stabilizer 100a includes a ferromagnetic (FM) coupling 114 between logical qubits 102 and 104, anti-ferromagnetic (AFM) couplings 116 and 118 between logical qubits 104 and 106, and 106 and 108, respectively, and an FM coupling 120 between logical qubits 108 and 102. Stabilizer 100a includes an FM coupling 122 between auxiliary qubit 112 and logical qubit 102, and AFM couplings 124, 126, and 128 between auxiliary qubit 112 and each of logical qubits 104,106, and 108, respectively. Stabilizer 100a includes an FM coupling 130 between auxiliary qubit 110 and logical qubit 102, and AFM couplings 132, 134, and 136 between auxiliary qubit 110 and each of logical qubits 104, 106, and 108, respectively. Stabilizer 100a also includes an FM coupling 138 between auxiliary qubits 110 and 112. Stabilizer 100a also includes an FM coupling 140 between logical qubits 102 and 106.

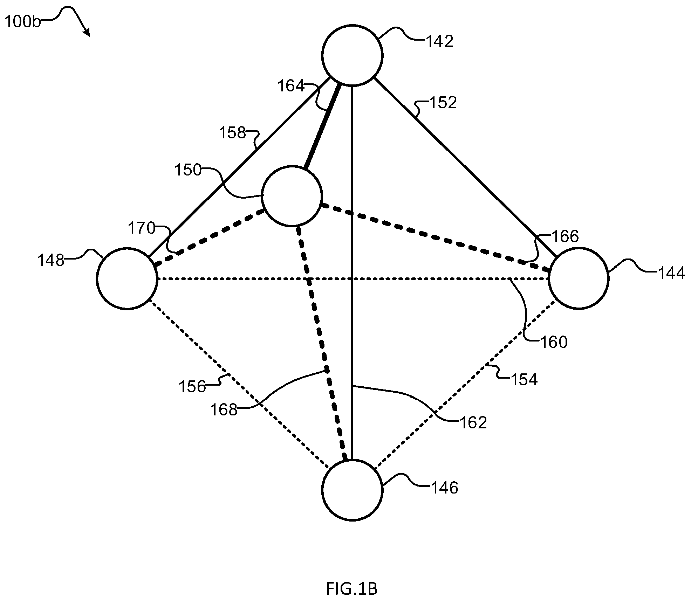

FIG. 1B is a schematic diagram of another example implementation of a *4*-qubit even-parity stabilizer 100b. Stabilizer 100b includes four logical qubits 142, 144, 146, and 148. Stabilizer 100b is a simpler implementation of stabilizer 100a of FIG. 1A. In stabilizer 100b, auxiliary qubits 110 and 112 of FIG. 1A are replaced by a single auxiliary qubit 150.

In FIG. 1B, ferromagnetic couplings between qubits are indicated by solid lines, and anti-ferromagnetic couplings between qubits are indicated by dashed lines.

Stabilizer 100b includes a ferromagnetic (FM) coupling 152 between logical qubits 142 and 144, anti-ferromagnetic (AFM) couplings 154 and 156 between logical qubits 144 and 146, and 146 and 148, respectively, and an FM coupling 158 between logical qubits 148 and 142. Stabilizer 100b includes an AFM coupling 160 between logical qubits 144 and 148, and an FM coupling 162 between logical qubits 142 and 146.

Stabilizer 100b includes an FM coupling 164 between auxiliary qubit 150 and logical qubit 142, and AFM couplings 166, 168, and 170 between auxiliary qubit 150 and each of logical qubits 144, 146, and 148, respectively.

In the example implementation illustrated in FIG. 1B, a strength of couplings 164, 166, 168, and 170 between auxiliary qubit 150 and each of logical qubits 142, 144, 146, and 148, respectively, is twice the strength of couplings between each of auxiliary qubits 110 and 112, and logical qubits 102, 104, 106, and 108 of FIG. 1A, and twice the strength of each of couplings 152, 154, 156, 158, 160, and 162 between respective pairs of logical qubits 142, 144, 146, and 148.

The strength of couplings is illustrated in FIG. 1B by a thickness of lines representing couplings. For example, the line representing coupling 164 is twice as thick as the line representing coupling 152.

An interaction Hamiltonian for stabilizer 100b of FIG. 1B can be expressed as follows: ${H}_{int} ∝ {\sum }_{i = 1}^{4} ξ \left(i\right) \left[2{{\hat{σ}}_{i}}^{z}{{\hat{σ}}_{p}}^{z}+{\sum }_{j > i}^{4} {{\hat{σ}}_{i}}^{z} {{\hat{σ}}_{j}}^{z}\right]$ where *ξ*(1) = -1 and *ξ*(*i*) = +1 otherwise.

### Circuits With Qubits and 4-Qubit Stabilizer

A shortcoming of the LHZ architecture is that practical implementations of the architecture can require high connectivity between logical qubits. For example, in a two-dimensional square lattice of logical qubits, with a *4*-qubit stabilizer (*e.g.,* stabilizer 100b of FIG. 1B), each logical qubit can be communicatively coupled to *4* nearest-neighbor qubits, *4* next-nearest-neighbor qubits, and *4* auxiliary qubits, for a total of *12* couplings per logical qubit.

There are ways to reduce the required connectivity between logical qubits. Referring to FIG. 1B, the couplings between logical qubits 142, 144, 146, and 148, and the couplings between auxiliary qubit 150 and logical qubits 142, 144, 146, and 148 can be symmetric in magnitude. If this is the case, logical qubits 142, 144, 146, and 148, and auxiliary qubit 150 can be communicatively coupled by a single linear coupling device to realize pairwise couplings.

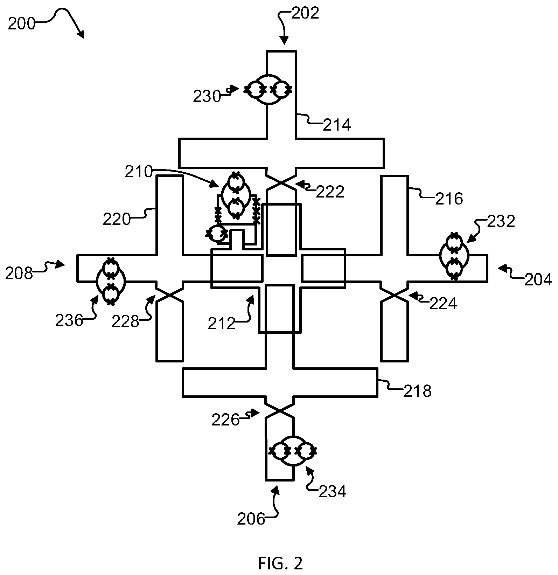

FIG. 2 is a schematic diagram of an example implementation of a circuit 200 comprising 4-qubit stabilizer 100b of FIG. 1B. In circuit 200, four logical qubits 202, 204, 206, and 208, and an auxiliary qubit 210 are communicatively coupled by a single linear coupling device 212 to realize pairwise couplings.

Each of logical qubits 202, 204, 206, and 208 includes a superconducting loop 214, 216, 218, and 220, respectively. Each of superconducting loops 214, 216, 218, and 220 includes a material that is superconducting at or below a critical temperature.

Each of superconducting loops 214, 216, 218, and 220 includes a crossover 222, 224, 226, and 228, respectively. In the cross-shaped arrangement of circuit 200, crossovers 222, 224, 226, and 228 can change the sign of interactions with logical qubit 202 relative to those between logical qubits 204, 206, and 208, and auxiliary qubit 210.

A superconducting loop topologically formed by a 180° out-of-plane rotation of a portion of the superconducting loop is referred to in the present application as a superconducting loop with a crossover. Current through the superconducting loop on one side of the crossover flows in a clockwise direction around the loop, and current through the superconducting loop on the other side of the crossover flows in an anti-clockwise direction around the loop. The two segments of the superconducting loop that cross over each other are galvanically isolated from each other at the crossover.

An interaction Hamiltonian for the system can be expressed as follows: ${\hat{H}}_{int} = \frac{1}{2} \left[{\sum }_{i = 1}^{4} {M}_{ci} {{\hat{I}}_{i}}^{p} + {M}_{cp} {{\hat{I}}_{p}}^{p}\right] {{\hat{I}}_{c}}^{p}$ Provided the coupling device is linear with susceptibility *χ*₁*^{c}*, then the persistent current operator for the coupling device can be expressed as follows: ${{\hat{I}}_{c}}^{p} = {{χ}_{1}}^{c} \left[{\sum }_{i = 1}^{4} {M}_{ci} {{\hat{I}}_{i}}^{p} + {M}_{cp} {{\hat{I}}_{p}}^{p}\right]$ where *Îᵢ^{p}* is the persistent current operator for the *i^{th}* qubit. By combining equations, the interaction Hamilton *Ĥᵢₙₜ* can be expressed as follows: ${\hat{H}}_{int} = {\sum }_{i = 1}^{4} \left[{M}_{ci}{M}_{cp}{{χ}_{1}}^{c}\left|{{I}_{q}}^{p}\right|\left|{{I}_{p}}^{p}\right|{{\hat{σ}}_{i}}^{z}{{\hat{σ}}_{p}}^{z}+{\sum }_{j > i}^{N} {M}_{ci} {M}_{cj} {{χ}_{1}}^{c} {\left|{{I}_{q}}^{p}\right|}^{2} {{\hat{σ}}_{i}}^{z} {{\hat{σ}}_{j}}^{z}\right]$ Choosing the following values can achieve a desired result: $- {M}_{c 1} = {M}_{c 2} = {M}_{c 3} = {M}_{c 4} ≡ {M}_{cq} > 0$ and ${M}_{cp} \left|{{I}_{p}}^{p}\right| = 2 {M}_{cq} \left|{{I}_{q}}^{p}\right|$

Referring again to FIG. 2, each of superconducting loops 214, 216, 218, and 220 is interrupted by a compound-compound Josephson junction (CCJJ) 230, 232, 234, and 236, respectively.

In the example implementation of FIG. 2, auxiliary qubit 210 (also referred to in the present application as a parity-enforcing qubit) is communicatively coupled to coupling device 212 by a fully galvanic CJJ coupling device. In other implementations, auxiliary qubit 210 is a different kind of qubit. In other implementations, auxiliary qubit 210 has a different form of communicative coupling to coupling device 212.

See, for example, US Patent 10,068,180 for a description of a probe qubit. See, for example, International PCT Publication No. WO2019126396 (A1) for a description of a galvanic CJJ coupling device.

Circuit 200 can be tiled to generate an LHZ architecture with only four (4) couplings per logical qubit.

Circuits (such as circuit 200 of FIG. 2) that use a 4-bit parity enforcer can have advantages over circuits that use a conventional 4-local interaction. For example, a 4-bit parity enforcer can be implemented using a set of 2-local interactions configured to have a stronger effective 4-local interaction than a conventional 4-local interaction.

### Josephson Parametric Amplifier

A parametric amplifier is generally used in the art to refer a device that amplifies a high-frequency input signal, for example, by sinusoidally varying a reactance of a circuit. A degenerate parametric amplifier is a phase-sensitive amplifier that can, at least in principle, amplify one of an in-phase and a quadrature component of a signal without introducing extra noise. A parametric amplifier can be based on a nonlinear inductance of a Josephson junction. Applications of a parametric amplifier can include quantum-limited amplification in the field of quantum information processing using superconducting circuits.

A Josephson parametric amplifier can include a superconducting transmission line resonator terminated by a DC SQUID (Superconducting Quantum Interference Device).

In one approach, a pump (also referred to in the present application as a drive) is used to modulate a current through a Josephson junction directly. In another approach (see, *e.g.,* T. Yamamoto et al., FLUX-DRIVEN JOSEPHSON PARAMETRIC AMPLIFIER, arXiv:0808.1386v1), a pump is used to modulate a flux through the DC SQUID. A resonant frequency of the superconducting transmission line resonator can be controlled by a DC flux also applied to the DC SQUID. As the pump and an input signal are applied to different ports, and the pump frequency is twice the resonant frequency, it can be straightforward to separate an output signal from the pump.

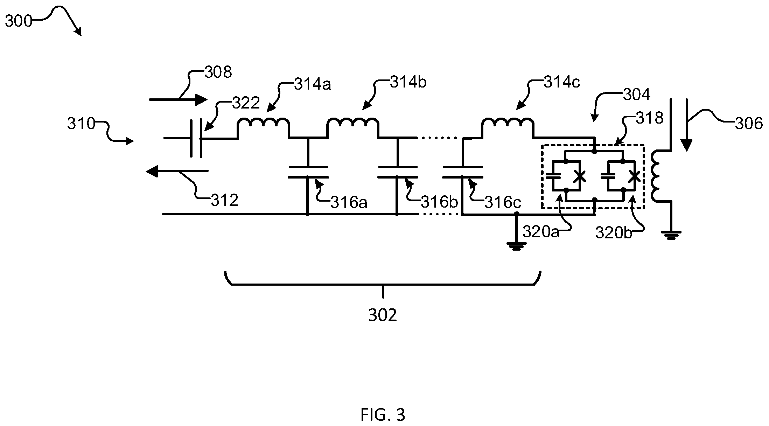

FIG. 3 is a schematic diagram of an example implementation of a Josephson parametric amplifier 300. JPA 300 includes a superconducting transmission line resonator 302 terminated by a DC SQUID 304. A pump 306 is used to modulate a current through DC SQUID 304.

An input signal 308 can be applied to a port 310 of superconducting transmission line resonator 302. An output signal 312 can be provided at port 310 of superconducting transmission line resonator 302. Superconducting transmission line resonator 302 includes inductances 314a, 314b, and 314c, and capacitances 316a, 316b, and 316c, each pair of inductances and capacitances (*e.g.,* a pair formed of inductance 314a and capacitance 316a) forming an LC circuit. Superconducting transmission line resonator 302 may include additional LC circuits in series (not shown in FIG. 3).

DC SQUID 304 includes a compound Josephson junction (CJJ) 318 (shown in FIG. 3 using dashed lines). CJJ 318 includes Josephson junctions 320a and 320b. Each of Josephson junctions 320a and 320b can have a respective intrinsic capacitance (as shown in FIG. 3, but not called out in FIG. 3 for clarity).

Superconducting transmission line resonator 302 further includes coupling capacitance 322.

### Quantum Annealing Platform Using JPAs

An Ising problem can be encoded in a network of two-photon-driven Kerr-nonlinear resonators (also referred to in the present application as KNRs). A single Ising spin can be mapped to two coherent states with opposite phases that can constitute a two-fold degenerate eigenspace of a two-photon-driven KNR in a frame rotating at the drive frequency.

In one circuit quantum electrodynamics (QED) implementation of a quantum annealer, a KNR is realized as a superconducting microwave resonator terminated by a flux-pumped SQUID (Superconducting Quantum Interference Device). A non-linear inductance of the flux-pumped SQUID can induce a Kerr-nonlinearity, and a two-photon drive can be created by flux-pumping the flux-pumped SQUID at twice a resonant frequency of the superconducting microwave resonator.

A Josephson parametric amplifier (JPA) can be similarly realized as a superconducting microwave resonator terminated by a flux-pumped SQUID, and so, in this context, a KNR can be considered as equivalent to a JPA. In one implementation, a SQUID loop of a JPA is driven by a flux pump with a tunable amplitude and frequency.

In some circuit implementations, a network of KNRs can be constructed using pairwise linear couplings, while still requiring only single-site drives.

Some optimization problems of interest can be represented using controllable long-range interactions between a large number of Ising spins, which can be a challenge to achieve in a hardware implementation. Long-range interactions may refer in the present application to interactions between non-adjacent nodes of a problem graph. One approach is to use a scheme (referred to in the present application as the LHZ scheme) that can map an Ising problem onto a graph with only local interactions. See, for example, Lechner W. et al., A QUANTUM ANNEALING ARCHITECTURE WITH ALL-TO-ALL CONNECTIVITY FROM LOCAL INTERACTIONS, Sci. Adv. 2015;1:e1500838 for a description of the LHZ scheme. The LHZ scheme can be implemented, for example, by embedding physical spins in an eigenbasis of two-photon-driven KNRs. (An eigenbasis is a basis for a vector space consisting of eigenvectors.) As described above, a KNR can be realized as a superconducting microwave resonator terminated by a flux-pumped SQUID.

S. Puri et al., QUANTUM ANNEALING WITH ALL-TO-ALL CONNECTED NONLINEAR OSCILLATORS, Nature Communications (2017) describes an example physical realization that includes four JPAs coupled by a Josephson junction (JJ). A non-linearity of the JJ can induce four-body coupling between the four JPAs. US 2018-0341874 A1 (SOCPRA SCIENCES ET GENIE S.E.C.) 29 November 2018 discloses a quantum processor comprising a first, a second, a third and a fourth Josephson Parametric Amplifiers (JPA) communicatively coupled to one another by a parity-enforcing stabilizer, where the parity-enforcing stabilizer may be a single central Josephson junction or a Josephson Ring Modulator.

A quantum annealing platform can be built, for example, from groups of four JPAs interacting via a single Josephson junction (JJ). Each JPA in a group can have a different resonant frequency to the other three JPAs in the group. Each group of four JPAs and coupling JJ is referred to in the present application as a building block.

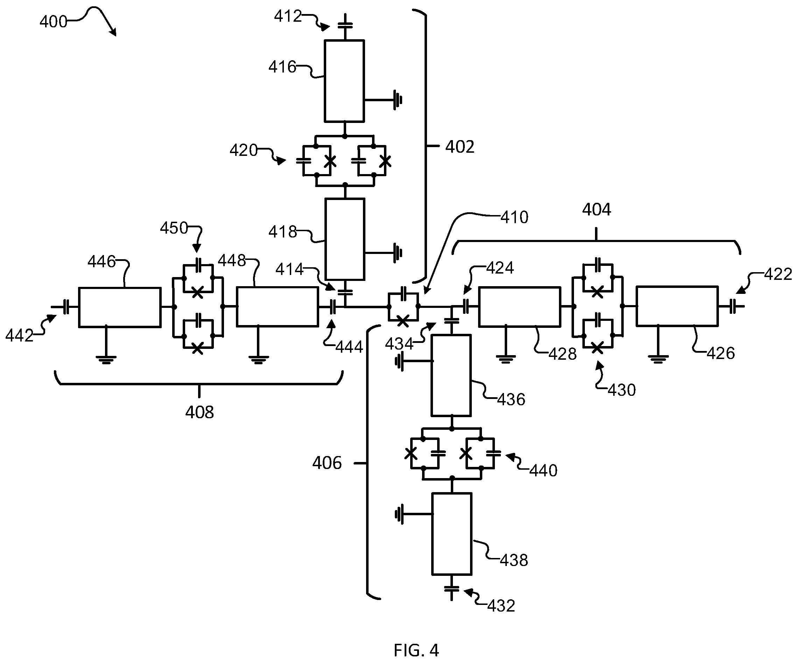

FIG. 4 is a schematic diagram of an example implementation of a building block 400 that can be used to build a quantum annealing platform. Building block 400 includes four JPAs 402, 404, 406, and 408, communicatively coupled by a JJ 410.
JPA 402 includes two coupling capacitors 412 and 414, and two resonators 416 and 418, communicatively coupled by a compound Josephson junction (CJJ) 420. JPA 404 includes two coupling capacitors 422 and 424, and two resonators 426 and 428, communicatively coupled by a CJJ 430. JPA 406 includes two coupling capacitors 442 and 444, and two resonators 446 and 448, communicatively coupled by a CJJ 450.

### Circuits With JPAs and 4-Qubit Stabilizer

While circuit 200 of FIG. 2 illustrates an implementation of an LHZ architecture using superconducting flux qubits, JPAs can be used in place of superconducting flux qubits.

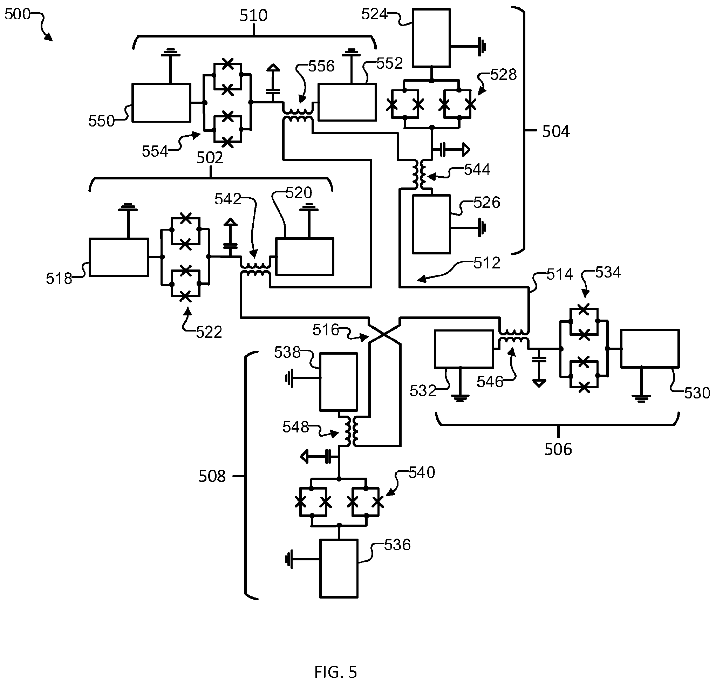

FIG. 5 is a schematic diagram of another example implementation of a building block 500 that can be used to build a quantum annealing platform. Building block 500 includes four JPAs 502, 504, 506, and 508, and an auxiliary JPA 510 are communicatively coupled by a single linear coupling device 512 to realize pairwise couplings. Coupling device 512 includes a superconducting loop 514. Superconducting loop 514 includes a material that is superconducting at or below a critical temperature. Superconducting loop 514 includes a crossover 516.

JPA 502 includes two resonators 518 and 520, communicatively coupled by a compound-compound Josephson junction (CCJJ) 522. JPA 504 includes two resonators 524 and 526, communicatively coupled by a CCJJ 528. JPA 506 includes two resonators 530 and 532, communicatively coupled by a CCJJ 534. JPA 508 includes two resonators 536 and 538, communicatively coupled by a CCJJ 540.

Coupling device 512 includes four inductive interfaces 542, 544, 546, and 548, each interface inductively communicatively coupled to a respective one of the four JPAs. Inductive interfaces 542, 544, 546, and 548 are shown in the example implementation of FIG. 5 as transformers that each include a pair of inductances, one inductance interrupting superconducting loop 514, and another inductance electrically communicatively coupled between one of the resonators of the JPA (*e.g.,* resonator 520 of JPA 502) and the CCJJ of the JPA (*e.g.,* CCJJ 522 of JPA 502). It can be beneficial to have the inductive coupling between coupling device 512 and each JPA at a position in the JPA where a respective current profile is strongest, or at least stronger, which is generally near the middle of the JPA.

In another implementation, inductive interfaces 542, 544, 546, and 548 include one inductance interrupting superconducting loop 514, and another inductance of an inner conductor of a coaxial transmission line of one of the resonators (*e.g.,* resonator 520 of JPA 502).

Auxiliary JPA 510 includes two resonators 550 and 552, communicatively coupled by a compound-compound Josephson junction (CCJJ) 554. In the example implementation of FIG. 5, auxiliary JPA 510 (also referred to in the present application as a parity-enforcing JPA) is communicatively coupled to coupling device 512 by an inductive interface 556. In other implementations, auxiliary JPA 510 has a different form of communicative coupling to coupling device 512.

### Scalable JPA Control

To realize a large-scale quantum annealing platform, it can be beneficial to implement a scalable JPA with scalable control biases, as described in the present application. The systems and methods described in the present application can also include advantageously replacing the single Josephson junction that couples the JPAs (*e.g.,* JJ 410 of FIG. 4) by a compound Josephson junction (CJJ) or by a compound-compound Josephson junction (CCJJ), the CCJJ comprising a pair of CJJs arranged in parallel with each other.

A CCJJ can be more robust to the presence of variations in fabrication, and can be tuned to introduce junction asymmetry between constituent CJJs as needed. Each CJJ of the CCJJ can be biased, for example, by a combination of an analog DC current bias and a bias supplied by a DAC (digital to analog converter).

A resonant frequency of the superconducting microwave resonator of the JPA can be tuned using a combination of the analog DC current bias and the bias supplied by the DAC.

The systems and methods described in the present application include: a) a circuit operable to control the strengths of the *X* and *Z* terms of the effective Hamiltonian, and b) a circuit operable to facilitate spectroscopy of the JPA, for example, during calibration.

The systems and methods described in the present application include a scalable coupling for JPAs.

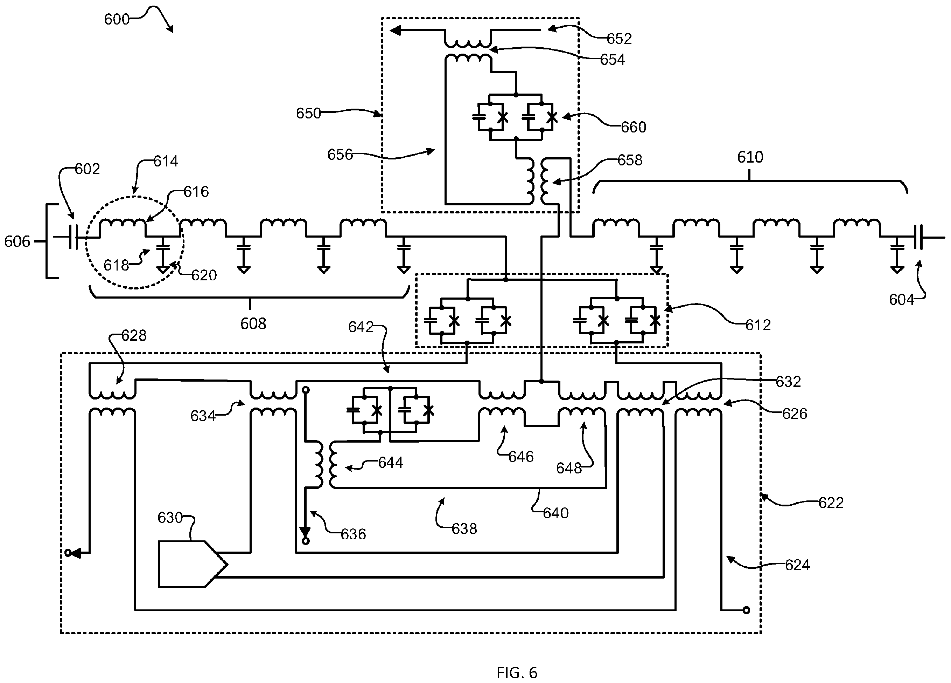

FIG. 6 is a schematic diagram of an example implementation of a circuit 600 that includes a scalable JPA with scalable control biases. Circuit 600 includes coupling capacitances 602 and 604. The location of coupling capacitances 602 and 604 in circuit 600 also indicate where other devices and/or circuits can be communicatively coupled to circuit 600.

Circuit 600 includes a JPA 606. JPA 606 includes resonators 608 and 610, and a compound-compound Josephson junction (CCJJ) 612. Resonators 608 and 610 are both communicatively coupled to CCJJ 612. Each of resonators 608 and 610 includes two or more respective LC circuits (*e.g.,* LC circuit 614, only one called out in FIG. 6 for clarity) electrically communicatively coupled in series with each other. LC circuit 614 includes an inductance 616, and a capacitor 618 that is electrically communicatively coupled to a ground terminal 620.

Circuit 600 includes a control circuit 622 (also referred to in the present application as CNTL-*XZ* 622). CNTL-*XZ* 622 can be used to control strengths of *X*-terms and *Z*-terms of an effective Hamiltonian via parametric and resonant drives at angular frequencies *ωₚ* = 2*ωᵣ* - *δ*₀(*t*) and *ωᵣ*, respectively. The function *δ*₀(*t*) is referred to in the present application as a de-tuning function, and can be a function of time. The de-tuning function can cause a resonator to be "off-resonance". The resonator can be brought into resonance during annealing, for example. The de-tuning function can define an annealing schedule. The de-tuning function can be a monotonic function or a non-monotonic function.

CJJ 220 of JPA 202 of FIG. 2 is advantageously replaced by CCJJ 612 in circuit 600 of FIG. 6. CCJJ 612 can be used a) to compensate for variations in fabrication of constituent Josephson junctions, and b) to intentionally introduce junction asymmetry as required for operation and/or calibration of circuit 600.

CCJJ 612 can be tuned by a combination of an analog DC current bias 624 by a first pair of inductive interfaces 626 and 628, and a digital-to-analog converter (DAC) 630 by a second pair of inductive interfaces 632 and 634.

A microwave drive 636 is communicatively coupled to CCJJ 612 via a tunable mutual inductance 638. Tunable mutual inductance 638 includes a superconducting loop 640 interrupted by a CJJ 642. Tunable mutual inductance 638 has an inductive interface 644 to microwave drive 636, and a third pair of inductive interfaces 646 and 648 to CCJJ 612.

In some implementations, each pair of the first pair of inductive interfaces 626 and 628, the second pair of inductive interfaces 632 and 634, and the third pair of inductive interfaces 646 and 648 may be replaced by a respective single inductive interface (also referred to in the present application as a transformer). A benefit of having a pair of inductive interfaces rather than a single inductive interface is that they can be mirror-symmetric with respect to CCJJ 612.

In some implementations, at least one pair of the first pair of inductive interfaces 626 and 628, the second pair of inductive interfaces 632 and 634, and the third pair of inductive interfaces 646 and 648 is mirror-symmetric with respect to CCJJ 612. Mirror-symmetry of inductive interfaces in a pair of inductive interfaces can eliminate, or at least reduce, the magnitude of unbalanced phases and/or unintended biases.

A function of tunable mutual inductance 638 is to facilitate per-device adjustment of a coupling strength between microwave drive 636 and a target device. Per-device adjustment can advantageously be used to compensate for variations in fabrication and/or impedance mismatches. Tunable mutual inductance 638 can have a combination of an analog current bias and a bias supplied by a DAC (not shown in FIG. 6) applied to CJJ 642.

Circuit 600 includes a control circuit 650 (also referred to in the present application as CNTL-*X*). CNTL-*X* includes a microwave drive 652 inductively coupled via interface 654 to a tunable mutual inductance 656 that is inductively coupled via interface 658 to CCJJ 612. Tunable mutual inductance 656 includes a CJJ 660. Tunable mutual inductance 656 can have a combination of an analog current bias and a bias supplied by a DAC (not shown in FIG. 6) applied to CJJ 660.

The above described method(s), process(es), or technique(s) could be implemented by a series of processor readable instructions stored on one or more non-transitory processor-readable media. Some examples of the above described method(s), process(es), or technique(s) method are performed in part by a specialized device such as an adiabatic quantum computer or a quantum annealer or a system to program or otherwise control operation of an adiabatic quantum computer or a quantum annealer, for instance a computer that includes at least one digital processor. The above described method(s), process(es), or technique(s) may include various acts, though those of skill in the art will appreciate that in alternative examples certain acts may be omitted and/or additional acts may be added. Those of skill in the art will appreciate that the illustrated order of the acts is shown for exemplary purposes only and may change in alternative examples. Some of the exemplary acts or operations of the above described method(s), process(es), or technique(s) are performed iteratively. Some acts of the above described method(s), process(es), or technique(s) may be performed during each iteration, after a plurality of iterations, or at the end of all the iterations.

The above description of illustrated implementations, including what is described in the Abstract, is not intended to be exhaustive or to limit the implementations to the precise forms disclosed. The teachings provided herein of the various implementations may be applied to other methods of quantum computation, not necessarily the exemplary methods for quantum computation generally described above.

The various implementations described above may be combined to provide further implementations.

These and other changes may be made to the implementations in light of the above-detailed description. In general, in the following claims, the terms used should not be construed to limit the claims to the specific implementations disclosed in the specification and the claims but should be construed to include all possible implementations along with the full scope to which such claims are entitled.

## Claims

1. A quantum processor comprising a first, a second, a third, and a fourth Josephson parametric amplifier (502, 504, 506, 508), wherein the first, the second, the third, and the fourth parametric amplifiers are logical qubits and are communicatively coupled to one another by a 4-qubit even-parity stabilizer auxiliary qubit, wherein the 4-qubit even-parity stabilizer auxiliary qubit includes:
a superconducting loop (514), the superconducting loop which includes a material that is superconducting at or below a critical temperature, the superconducting loop which includes a crossover (516), a first segment on a first side of the crossover and a second segment on a second side of the crossover, the first and second segment of the superconducting loop galvanically isolated from each other at the crossover;
a first, a second, a third, and a fourth inductance (542, 544, 546, 548) of the superconducting loop, each of the first, the second, the third, and the fourth inductance inductively communicatively coupled to an inductance of a respective Josephson parametric amplifier; and
a parity-enforcing Josephson parametric amplifier (510), wherein the parity-enforcing Josephson parametric amplifier is communicatively coupled to the superconducting loop.

2. The quantum processor of claim 1, wherein each of the first, the second, the third, and the fourth Josephson parametric amplifiers comprises a respective pair of superconducting microwave resonators (518, 520, 524, 526, 530, 532, 536, 538), each superconducting microwave resonator of the respective pair of superconducting microwave resonators communicatively coupled to each other by a compound-compound Josephson junction (522, 528, 534, 540).

3. The quantum processor of claim 2, wherein each of the first, the second, the third and the fourth Josephson parametric amplifiers comprises:
a respective compound-compound Josephson junction (612) ; and
a respective first control circuit (622) communicatively coupled to the respective compound-compound Josephson junction of the first, the second, the third and the fourth Josephson parametric amplifiers.

4. The quantum processor of claim 3, wherein each respective first control circuit (622) is inductively communicatively coupled to the respective compound-compound Josephson junction (612) of the first, the second, the third and the fourth Josephson parametric amplifiers.

5. The quantum processor of claim 3, wherein each respective first control circuit comprises:
an analog DC current bias (624), the analog DC current bias communicatively coupled to the respective compound-compound Josephson junction (612) of the first, the second, the third and the fourth Josephson parametric amplifiers;
a digital-to-analog converter (DAC) (630), the DAC communicatively coupled to the respective compound-compound Josephson junction (612) of the first, the second, the third and the fourth Josephson parametric amplifiers; and
a respective first microwave drive (636) communicatively coupled to a respective first tunable mutual inductance (638), wherein the respective first tunable mutual inductance is communicatively coupled to the respective compound-compound Josephson junction (612) of the first, the second, the third and the fourth Josephson parametric amplifiers.

6. The quantum processor of claim 5, wherein the respective first tunable mutual inductance (638) of each of the respective first control circuit is inductively communicatively coupled to the respective compound-compound Josephson junction (612) of the first, the second, the third and the fourth Josephson parametric amplifiers.

7. The quantum processor of claim 5, wherein each of the analog DC current bias (624) and each of the DAC (630) of the respective first control circuit (622) are inductively communicatively coupled to the respective compound-compound Josephson junction (612) of the first, the second, the third and the fourth Josephson parametric amplifiers.

8. The quantum processor of claim 5, wherein each of the respective first tunable mutual inductances (638) comprises a superconducting loop (640) interrupted by a compound Josephson junction (642).

9. The quantum processor of claim 5, wherein each respective first control circuit (622) is operable to control strengths of *X*-terms and *Z*-terms of an effective Hamiltonian via a resonant drive at a first angular frequency, and via a parametric drive at a second angular frequency, the second angular frequency equal to a difference between twice the first angular frequency and a time-dependent de-tuning frequency.

10. The quantum processor of claim 5, wherein each of the first, the second, the third and the fourth Josephson parametric amplifiers further comprises a respective second control circuit (650), each respective second control circuit comprising a respective second microwave drive (652) communicatively coupled to a respective second tunable mutual inductance (656), wherein each respective second tunable mutual inductance is communicatively coupled to the respective compound-compound Josephson junction (612) of the first, the second, the third and the fourth Josephson parametric amplifiers.

11. The quantum processor of claim 10, wherein each respective second control circuit (650) is inductively communicatively coupled to the respective compound-compound Josephson junction (612) of the first, the second, the third and the fourth Josephson parametric amplifiers.

12. The quantum processor of claim 10, wherein each respective second tunable mutual inductance (656) of the respective second control circuit (650) is inductively communicatively coupled to the respective compound-compound Josephson junction (612) of the first, the second, the third and the fourth Josephson parametric amplifiers.

13. The quantum processor of claim 10, wherein each respective second tunable mutual inductance (656) comprises a superconducting loop interrupted by a compound Josephson junction (660).

14. The quantum processor of claim 2, each resonator of the respective pair of superconducting resonators of the first, the second, the third, and the fourth Josephson parametric amplifiers is a superconducting microwave resonator.

15. The quantum processor of claim 14, wherein each of the superconducting microwave resonators in the respective pair of superconducting resonators of the first, the second, the third, and the fourth Josephson parametric amplifiers is one of: a coaxial transmission line resonator, and a ladder circuit comprising a plurality of LC circuits electrically communicatively coupled in series with one another.

## Patentansprüche

1. Ein Quantenprozessor, der einen ersten, einen zweiten, einen dritten und einen vierten parametrischen Josephson-Verstärker (502, 504, 506, 508) beinhaltet, wobei der erste, der zweite, der dritte und der vierte parametrische Verstärker logische Qubits sind und durch ein 4-Qubit-Stabilisator-Hilfsqubit für gerade Parität kommunikativ miteinander gekoppelt sind, wobei das 4-Qubit-Stabilisator-Hilfsqubit für gerade Parität Folgendes umfasst:
eine supraleitende Schleife (514), wobei die supraleitende Schleife ein Material umfasst, das bei oder unterhalb einer kritischen Temperatur supraleitend ist, wobei die supraleitende Schleife eine Überkreuzung (516), ein erstes Segment auf einer ersten Seite der Überkreuzung und ein zweites Segment auf einer zweiten Seite der Überkreuzung umfasst, wobei das erste und das zweite Segment der supraleitenden Schleife an der Überkreuzung galvanisch voneinander isoliert sind;
eine erste, eine zweite, eine dritte und eine vierte Induktivität (542, 544, 546, 548) der supraleitenden Schleife, wobei jede der ersten, der zweiten, der dritten und der vierten Induktivität induktiv kommunikativ mit einer Induktivität eines jeweiligen parametrischen Josephson-Verstärkers gekoppelt ist; und
einen paritätserzwingenden parametrischen Josephson-Verstärker (510), wobei der paritätserzwingende parametrische Josephson-Verstärker kommunikativ mit der supraleitenden Schleife gekoppelt ist.

2. Quantenprozessor gemäß Anspruch 1, wobei jeder des ersten, des zweiten, des dritten und des vierten parametrischen Josephson-Verstärkers ein jeweiliges Paar supraleitender Mikrowellenresonatoren (518, 520, 524, 526, 530, 532, 536, 538) beinhaltet, wobei jeder supraleitende Mikrowellenresonator des jeweiligen Paars supraleitender Mikrowellenresonatoren durch einen Verbund-Verbund-Josephson-Verbindungsübergang (522, 528, 534, 540) kommunikativ miteinander gekoppelt ist.

3. Quantenprozessor gemäß Anspruch 2, wobei jeder des ersten, des zweiten, des dritten und des vierten parametrischen Josephson-Verstärkers Folgendes beinhaltet:
einen jeweiligen Verbund-Verbund-Josephson-Verbindungsübergang (612); und
eine jeweilige erste Steuerschaltung (622), die kommunikativ mit dem jeweiligen Verbund-Verbund-Josephson-Verbindungsübergang des ersten, des zweiten, des dritten und des vierten parametrischen Josephson-Verstärkers gekoppelt ist.

4. Quantenprozessor gemäß Anspruch 3, wobei jede jeweilige erste Steuerschaltung (622) induktiv kommunikativ mit dem jeweiligen Verbund-Verbund-Josephson-Verbindungsübergang (612) des ersten, des zweiten, des dritten und des vierten parametrischen Josephson-Verstärkers gekoppelt ist.

5. Quantenprozessor gemäß Anspruch 3, wobei jede jeweilige erste Steuerschaltung Folgendes beinhaltet:
einen analogen Gleichstrom-Bias (624), wobei der analoge Gleichstrom-Bias kommunikativ mit dem jeweiligen Verbund-Verbund-Josephson-Verbindungsübergang (612) des ersten, des zweiten, des dritten und des vierten parametrischen Josephson-Verstärkers gekoppelt ist;
einen Digital-Analog-Wandler (DAC) (630), wobei der DAC kommunikativ mit dem jeweiligen Verbund-Verbund-Josephson-Verbindungsübergang (612) des ersten, des zweiten, des dritten und des vierten parametrischen Josephson-Verstärkers gekoppelt ist; und
eine jeweilige erste Mikrowellenanregung (636), die kommunikativ mit einer jeweiligen ersten abstimmbaren Gegeninduktivität (638) gekoppelt ist, wobei die jeweilige erste abstimmbare Gegeninduktivität kommunikativ mit dem jeweiligen Verbund-Verbund-Josephson-Verbindungsübergang (612) des ersten, des zweiten, des dritten und des vierten parametrischen Josephson-Verstärkers gekoppelt ist.

6. Quantenprozessor gemäß Anspruch 5, wobei die jeweilige erste abstimmbare Gegeninduktivität (638) jeder jeweiligen ersten Steuerschaltung induktiv kommunikativ mit dem jeweiligen Verbund-Verbund-Josephson-Verbindungsübergang (612) des ersten, des zweiten, des dritten und des vierten parametrischen Josephson-Verstärkers gekoppelt ist.

7. Quantenprozessor gemäß Anspruch 5, wobei jeder analoge Gleichstrom-Bias (624) und jeder DAC (630) der jeweiligen ersten Steuerschaltung (622) induktiv kommunikativ mit dem jeweiligen Verbund-Verbund-Josephson-Verbindungsübergang (612) des ersten, des zweiten, des dritten und des vierten parametrischen Josephson-Verstärkers gekoppelt sind.

8. Quantenprozessor gemäß Anspruch 5, wobei jede der jeweiligen ersten abstimmbaren Gegeninduktivitäten (638) eine supraleitende Schleife (640) beinhaltet, die durch einen Verbund-Josephson-Verbindungsübergang (642) unterbrochen ist.

9. Quantenprozessor gemäß Anspruch 5, wobei jede jeweilige erste Steuerschaltung (622) betreibbar ist, um Stärken von *X*-Termen und *Z*-Termen eines effektiven Hamilton-Operators über eine resonante Anregung bei einer ersten Winkelfrequenz und über eine parametrische Anregung bei einer zweiten Winkelfrequenz zu steuern, wobei die zweite Winkelfrequenz gleich einer Differenz zwischen dem Zweifachen der ersten Winkelfrequenz und einer zeitabhängigen Verstimmungsfrequenz ist.

10. Quantenprozessor gemäß Anspruch 5, wobei jeder des ersten, des zweiten, des dritten und des vierten parametrischen Josephson-Verstärkers ferner eine jeweilige zweite Steuerschaltung (650) beinhaltet, wobei jede jeweilige zweite Steuerschaltung eine jeweilige zweite Mikrowellenanregung (652) beinhaltet, die kommunikativ mit einer jeweiligen zweiten abstimmbaren Gegeninduktivität (656) gekoppelt ist, wobei jede jeweilige zweite abstimmbare Gegeninduktivität kommunikativ mit dem jeweiligen Verbund-Verbund-Josephson-Verbindungsübergang (612) des ersten, des zweiten, des dritten und des vierten parametrischen Josephson-Verstärkers gekoppelt ist.

11. Quantenprozessor gemäß Anspruch 10, wobei jede jeweilige zweite Steuerschaltung (650) induktiv kommunikativ mit dem jeweiligen Verbund-Verbund-Josephson-Verbindungsübergang (612) des ersten, des zweiten, des dritten und des vierten parametrischen Josephson-Verstärkers gekoppelt ist.

12. Quantenprozessor gemäß Anspruch 10, wobei jede jeweilige zweite abstimmbare Gegeninduktivität (656) der jeweiligen zweiten Steuerschaltung (650) induktiv kommunikativ mit dem jeweiligen Verbund-Verbund-Josephson-Verbindungsübergang (612) des ersten, des zweiten, des dritten und des vierten parametrischen Josephson-Verstärkers gekoppelt ist.

13. Quantenprozessor gemäß Anspruch 10, wobei jede jeweilige zweite abstimmbare Gegeninduktivität (656) eine supraleitende Schleife beinhaltet, die durch einen Verbund-Josephson-Verbindungsübergang (660) unterbrochen ist.

14. Quantenprozessor gemäß Anspruch 2, jeder Resonator des jeweiligen Paars supraleitender Resonatoren des ersten, des zweiten, des dritten und des vierten parametrischen Josephson-Verstärkers ist ein supraleitender Mikrowellenresonator.

15. Quantenprozessor gemäß Anspruch 14, wobei jeder der supraleitenden Mikrowellenresonatoren in dem jeweiligen Paar supraleitender Resonatoren des ersten, des zweiten, des dritten und des vierten parametrischen Josephson-Verstärkers einer von Folgendem ist: ein Koaxial-Übertragungsleitungsresonator und eine Kettenleiterschaltung, die eine Vielzahl von LC-Schaltungen beinhaltet, die elektrisch kommunikativ miteinander in Reihe gekoppelt sind.

## Revendications

1. Un processeur quantique comprenant un premier, un deuxième, un troisième, et un quatrième amplificateur paramétrique Josephson (502, 504, 506, 508), où les premier, deuxième, troisième, et quatrième amplificateurs paramétriques sont des qubits logiques et sont couplés en communication les uns aux autres par un qubit auxiliaire stabilisateur de parité paire à 4 qubits, où le qubit auxiliaire stabilisateur de parité paire à 4 qubits inclut :
une boucle supraconductrice (514), la boucle supraconductrice qui inclut un matériau qui est supraconducteur à une température critique ou en dessous de celle-ci, la boucle supraconductrice qui inclut un croisement (516), un premier segment sur un premier côté du croisement et un deuxième segment sur un deuxième côté du croisement, les premier et deuxième segments de la boucle supraconductrice étant isolés galvaniquement l'un de l'autre au niveau du croisement ;
une première, une deuxième, une troisième, et une quatrième inductance (542, 544, 546, 548) de la boucle supraconductrice, chacune parmi la première, la deuxième, la troisième, et la quatrième inductance étant couplée en communication inductive à une inductance d'un amplificateur paramétrique Josephson respectif ; et
un amplificateur paramétrique Josephson imposant la parité (510), où l'amplificateur paramétrique Josephson imposant la parité est couplé en communication à la boucle supraconductrice.

2. Le processeur quantique de la revendication 1, où chacun parmi les premier, deuxième, troisième, et quatrième amplificateurs paramétriques Josephson comprend une paire respective de résonateurs micro-ondes supraconducteurs (518, 520, 524, 526, 530, 532, 536, 538), chaque résonateur micro-ondes supraconducteur de la paire respective de résonateurs micro-ondes supraconducteurs étant couplé en communication à l'autre par une jonction Josephson composée-composée (522, 528, 534, 540).

3. Le processeur quantique de la revendication 2, où chacun parmi les premier, deuxième, troisième et quatrième amplificateurs paramétriques Josephson comprend :
une jonction Josephson composée-composée respective (612) ; et
un premier circuit de commande respectif (622) couplé en communication à la jonction Josephson composée-composée respective des premier, deuxième, troisième et
quatrième amplificateurs paramétriques Josephson.

4. Le processeur quantique de la revendication 3, où chaque premier circuit de commande respectif (622) est couplé en communication inductive à la jonction Josephson composée-composée respective (612) des premier, deuxième, troisième et quatrième amplificateurs paramétriques Josephson.

5. Le processeur quantique de la revendication 3, où chaque premier circuit de commande respectif comprend :
une polarisation de courant CC analogique (624), la polarisation de courant CC analogique étant couplée en communication à la jonction Josephson composée-composée respective (612) des premier, deuxième, troisième et quatrième amplificateurs paramétriques Josephson ;
un convertisseur numérique-analogique (DAC) (630), le DAC étant couplé en communication à la jonction Josephson composée-composée respective (612) des premier, deuxième, troisième et quatrième amplificateurs paramétriques Josephson ; et
une première excitation micro-ondes respective (636) couplée en communication à une première inductance mutuelle accordable respective (638), où la première inductance mutuelle accordable respective est couplée en communication à la jonction Josephson composée-composée respective (612) des premier, deuxième, troisième et quatrième amplificateurs paramétriques Josephson.

6. Le processeur quantique de la revendication 5, où la première inductance mutuelle accordable respective (638) de chaque premier circuit de commande respectif est couplée en communication inductive à la jonction Josephson composée-composée respective (612) des premier, deuxième, troisième et quatrième amplificateurs paramétriques Josephson.

7. Le processeur quantique de la revendication 5, où chaque polarisation de courant CC analogique (624) et chaque DAC (630) du premier circuit de commande respectif (622) sont couplés en communication inductive à la jonction Josephson composée-composée respective (612) des premier, deuxième, troisième et quatrième amplificateurs paramétriques Josephson.

8. Le processeur quantique de la revendication 5, où chacune parmi les premières inductances mutuelles accordables respectives (638) comprend une boucle supraconductrice (640) interrompue par une jonction Josephson composée (642).

9. Le processeur quantique de la revendication 5, où chaque premier circuit de commande respectif (622) est exploitable pour commander des intensités de termes *X* et de termes *Z* d'un hamiltonien effectif par l'intermédiaire d'une excitation résonante à une première fréquence angulaire, et par l'intermédiaire d'une excitation paramétrique à une deuxième fréquence angulaire, la deuxième fréquence angulaire étant égale à une différence entre deux fois la première fréquence angulaire et une fréquence de désaccord dépendante du temps.

10. Le processeur quantique de la revendication 5, où chacun parmi les premier, deuxième, troisième et quatrième amplificateurs paramétriques Josephson comprend en outre un deuxième circuit de commande respectif (650), chaque deuxième circuit de commande respectif comprenant une deuxième excitation micro-ondes respective (652) couplée en communication à une deuxième inductance mutuelle accordable respective (656), où chaque deuxième inductance mutuelle accordable respective est couplée en communication à la jonction Josephson composée-composée respective (612) des premier, deuxième, troisième et quatrième amplificateurs paramétriques Josephson.

11. Le processeur quantique de la revendication 10, où chaque deuxième circuit de commande respectif (650) est couplé en communication inductive à la jonction Josephson composée-composée respective (612) des premier, deuxième, troisième et quatrième amplificateurs paramétriques Josephson.

12. Le processeur quantique de la revendication 10, où chaque deuxième inductance mutuelle accordable respective (656) du deuxième circuit de commande respectif (650) est couplée en communication inductive à la jonction Josephson composée-composée respective (612) des premier, deuxième, troisième et quatrième amplificateurs paramétriques Josephson.

13. Le processeur quantique de la revendication 10, où chaque deuxième inductance mutuelle accordable respective (656) comprend une boucle supraconductrice interrompue par une jonction Josephson composée (660).

14. Le processeur quantique de la revendication 2, chaque résonateur de la paire respective de résonateurs supraconducteurs des premier, deuxième, troisième, et quatrième amplificateurs paramétriques Josephson est un résonateur micro-ondes supraconducteur.

15. Le processeur quantique de la revendication 14, où chacun parmi les résonateurs micro-ondes supraconducteurs dans la paire respective de résonateurs supraconducteurs des premier, deuxième, troisième, et quatrième amplificateurs paramétriques Josephson est l'un parmi : un résonateur de ligne de transmission coaxiale, et un circuit en échelle comprenant une pluralité de circuits LC couplés en communication électrique en série les uns aux autres.
